# EUROPÄISCHE PATENTSCHRIFT

(11) **EP 3 485 545 B1**
(45) Veröffentlichungstag und Bekanntmachung des Hinweises auf die Patenterteilung: **09.06.2021**
(21) Anmeldenummer: 17742411.6
(22) Anmeldetag: 12.07.2017
(51) Int. Cl.: H01S 3/10, H01S 3/13

(54) **LASERPULSGENERATOR UND VERFAHREN ZUR ERZEUGUNG EINES LASERPULSES**
LASER PULSE GENERATOR AND METHOD FOR GENERATING A LASER PULSE
GÉNÉRATEUR D'IMPULSIONS LASER ET PROCÉDÉ PERMETTANT DE PRODUIRE UNE IMPULSION LASER

(30) Priorität: 14.07.2016 DE 102016212929
(43) Veröffentlichungstag der Anmeldung: 22.05.2019
(73) Patentinhaber: TRUMPF Laser GmbH, 78713 Schramberg (DE)
(72) Erfinder: FLAIG, Rainer, 78664 Eschbronn (DE); GLUNK, Daniel, 78737 Fluorn-Winzeln (DE); RAPP, Oliver, 78664 Eschbronn-Mariazell (DE)
(74) Vertreter: Kohler Schmid Möbus Patentanwälte
(86) Internationale Anmeldenummer: PCT/EP2017/067620
(87) Internationale Veröffentlichungsnummer: WO 2018/011305

(56) Entgegenhaltungen:
- CA-A1- 2 729 088
- US-A1- 2009 323 741
- US-A1- 2012 187 860
- US-A1- 2014 218 791

## Beschreibung

Die Erfindung betrifft einen Laserpulsgenerator mit einer Pulsformgenerierungseinrichtung, aufweisend einen Pulsformspeicher zur Speicherung von Daten und einen damit verbundenen Digital-Analog-Wandler (DAC), einen ersten Anschluss zum Anschluss einer Startsignalleitung eines Startsignalpfads, einen zweiten Anschluss zum Anschluss einer Taktsignalleitung, einen dritten Anschluss zum Anschluss einer Pulsleitung, wobei der erste und zweite Anschluss so mit dem Pulsformspeicher und dem DAC verbunden sind, dass bei einem vorgegebenen Startsignal Daten vom Pulsformspeicher zum DAC geleitet und vom DAC, insbesondere im Takt eines Taktsignals, in einen Ausgangspuls gewandelt wird, der am dritten Anschluss zur Ansteuerung eines Treibers für eine Laserdiode bereit gestellt wird, sowie eine Takteinheit, die mit dem zweiten Anschluss über die Taktsignalleitung verbunden ist. Ein Laserpulsgenerator ähnlicher Art ist beispielsweise in CA 2 729 088 A1 beschrieben.

Weiterhin betrifft die Erfindung ein Verfahren zur Erzeugung eines Laserpulses mit den Schritten:
a. Ausgabe von Daten aus einem Pulsformspeicher an einen DAC in Reaktion auf ein Startsignal.
b. Erzeugen eines Ausgangspulses im DAC, insbesondere im Takt eines Taktsignals einer Takteinheit, und Ausgabe des Ausgangspulses.

Laserdioden erzeugen einen Laserpuls, indem ein Treiber der Laserdiode mit einer Laserpulsform angesteuert wird. Laserpulsformen können auf einfache Weise über einen Digital-Analog-Wandler ausgegeben werden. Hierbei wird mit einem Ausgabetakt der Speicherinhalt eines Pulsformspeichers über den Digital-Analog-Wandler ausgegeben. Bei einer vom Anwender gestarteten so genannten "Pulse on Demand"-Triggerung kann es zu einem Ausgabejitter kommen, da das Start- (Trigger-) Ereignis nicht zwingend mit dem Ausgabetakt des Speichers bzw. DAC korreliert.

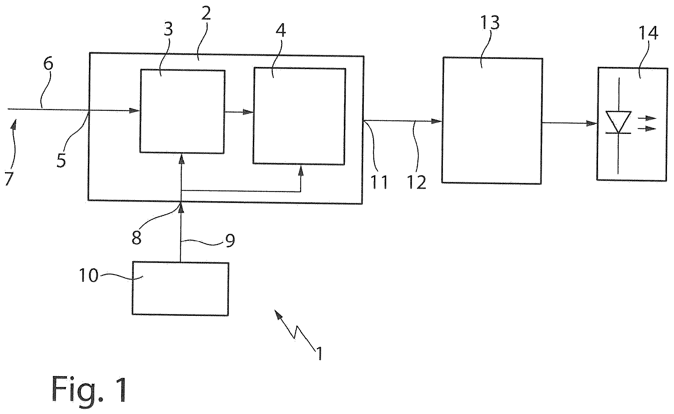

In der Figur 1 ist ein Laserpulsgenerator 1 dargestellt. Der Laserpulsgenerator 1 umfasst dabei eine Pulsformgenerierungseinrichtung 2, die einen Pulsformspeicher 3 zur Speicherung einer Pulsform aufweist. Im Pulsformspeicher 3 ist die Pulsform als digital codierte Pulsform abgelegt. Der Pulsformspeicher 3 ist mit einem Digital-Analog-Wandler 4 verbunden. Durch den Digital-Analog-Wandler 4 kann eine digital codierte Pulsform in eine analoge Pulsform bzw. einen Ausgangspuls gewandelt werden. Die Pulsformgenerierungseinrichtung 2 weist einen ersten Anschluss 5 zum Anschluss einer Startsignalleitung 6 eines Startsignalpfads 7 auf. Über den Startsignalpfad 7 kann ein Startsignal übertragen werden. Ein zweiter Anschluss 8 ist zum Anschluss einer Taktsignalleitung 9 vorgesehen. An die Taktsignalleitung 9 ist eine Takteinheit 10 angeschlossen. Diese versorgt den Pulsformspeicher 3 und den Digital-Analog-Wandler 4 mit einem Taktsignal. An den Ausgangsanschluss 11 der Pulsformgenerierungseinrichtung 2 ist über eine Pulsleitung 12 ein Treiber 13 für eine Laserdiode 14 angeschlossen. Wenn ein entsprechendes Startsignal den Pulsformspeicher 3 erreicht, wird an dessen Ausgang die digital codierte Pulsform im Takt der Takteinheit 10 ausgegeben und dann im Digital-Analog-Wandler 4 in ein analoges Ausgangssignal gewandelt. Wenn ein Zeitversatz zwischen dem Auftreten des Startsignals und dem Taktsignal der Takteinheit 10 besteht, kann es zu einem Ausgabejitter des am Ausgang 11 ausgegebenen Ausgangssignals kommen.

Aufgabe der vorliegenden Erfindung ist es, einen Laserpulsgenerator derart weiter zu bilden und ein Verfahren zur Erzeugung eines Laserpulses bereit zu stellen, mit denen der Ausgabejitter reduziert werden kann.

Gelöst wird diese Aufgabe erfindungsgemäß durch einen Laserpulsgenerator mit
a) einer Pulsformgenerierungseinrichtung, aufweisend
   i. einen Pulsformspeicher zur Speicherung von Daten, insbesondere einer digital codierten Pulsform, und einen damit verbundenen Digital-Analog-Wandler (DAC),
   ii. einen ersten Anschluss zum Anschluss einer Startsignalleitung eines Startsignalpfads,
   iii. einen zweiten Anschluss zum Anschluss einer Taktsignalleitung,
   iv. einen dritten Anschluss zum Anschluss einer Pulsleitung, wobei der erste und zweite Anschluss so mit dem Pulsformspeicher und dem DAC verbunden sind, dass bei einem vorgegebenen Startsignal Daten vom Pulsformspeicher zum DAC geleitet und vom DAC, insbesondere im Takt eines Taktsignals, in einen Ausgangspuls gewandelt wird, der am dritten Anschluss zur Ansteuerung eines Treibers für eine Laserdiode bereitgestellt wird,
b. eine Takteinheit, die mit dem zweiten Anschluss über die Taktsignalleitung verbunden ist, wobei
c. die Takteinheit einen Rücksetzanschluss aufweist, der mit dem Startsignalpfad verbunden ist.

Der Pulsformspeicher ist dabei ausgelegt, ein digitalisiertes Signal, insbesondere ein digitales Wort, zu speichern. Der im Pulsformspeicher gespeicherte Speicherinhalt definiert dabei eine bestimmte Pulsform für den Ausgangspuls des DAC. Der Ausgangspuls des DAC kann dann einem Treiber zugeführt werden. Der Treiber kann aus dem ihm zugeführten Signal den Laserpuls für eine Laserdiode generieren. Daher wird im Folgenden davon gesprochen, dass im Pulsformspeicher eine digital codierte Pulsform gespeichert ist. Dabei kann vorgesehen sein, dass im Pulsformspeicher lediglich eine digital codierte Pulsform gespeichert ist, die einmal in den Pulsformspeicher geschrieben wird. Es kann auch vorgesehen sein, dass der Pulsformspeicher beschreibbar ist und somit unterschiedliche digital codierte Pulsformen speicherbar sind. Weiterhin ist es denkbar, dass im Pulsformspeicher unterschiedliche digital codierte Pulsformen gespeichert sind und ausgewählt werden kann, welche digital codierte Pulsform an den Digital-Analog-Wandler ausgegeben werden soll.
Insbesondere können im Pulsformspeicher Daten digital gespeichert sein.

Durch den erfindungsgemäßen Laserpulsgenerator erfolgt eine Synchronisierung der Takteinheit mit dem Startsignal oder einem damit in Beziehung stehenden Signal. Auf diese Art und Weise kann der Ausgabejitter des Ausgangssignals am Ausgang der Pulsformgenerierungseinrichtung reduziert werden.

Gemäß einer Ausführungsform kann vorgesehen sein, dass die Takteinheit als Start-Stopp-Oszillator ausgebildet ist. Ein Start-Stopp-Oszillator ist ein Oszillator, der durch ein Signal angehalten werden kann und anschließend wieder freigegeben werden kann. Dies bedeutet, dass der Startzeitpunkt der Ausgabe eines Taktsignals durch den Oszillator eingestellt, festgelegt oder beeinflusst werden kann. Insbesondere kann der Start-Stopp-Oszillator durch das Startsignal oder ein damit in Beziehung stehendes Signal kurz angehalten werden, so dass während dieser Anhaltezeit die Daten im Pulsformspeicher durch das Startsignal freigegeben werden können und anschließend der Oszillator gestartet bzw. freigegeben werden kann, so dass die Daten aus dem Pulsformspeicher im Takt der Takteinheit ausgegeben werden können und/oder die vom Pulsformspeicher ausgegebenen Daten im Takt des Taktsignals im DAC in einen Ausgabepuls gewandelt werden.

Gemäß einer alternativen Ausführungsform kann vorgesehen sein, dass die Takteinheit einen rücksetzbaren Frequenzteiler und eine Taktquelle aufweist. Die Taktquelle kann eine Taktfrequenz aufweisen bzw. ein Signal mit einer Taktfrequenz ausgeben, die größer ist, als die Taktfrequenz am Ausgang der Takteinheit. Die Taktfrequenz der Taktquelle kann ein ganzzahliges Vielfaches, insbesondere wenigstens das Doppelte, weiter bevorzugt wenigstens das Vierfache, der Taktfrequenz am Ausgang der Takteinheit aufweisen. Insbesondere kann die Taktfrequenz der Taktquelle größer sein, als für den Betrieb des DAC und/oder des Pulsformspeichers zulässig. Durch den Frequenzteiler kann die Frequenz in einen Bereich gebracht/gesenkt werden, so dass z.B. der DAC oder der Pulsformspeicher damit betrieben werden können. Durch den Frequenzteiler kann die Frequenz des von der Taktquelle ausgegebenen Signals in einem vorgegebenen Verhältnis geteilt werden. Dabei ist der Frequenzteiler vorzugsweise mit dem zweiten Anschluss über die Taktsignalleitung verbunden. Das vom Frequenzteiler ausgegebene Signal kann somit die Ausgabe der Daten aus dem Pulsformspeicher und/oder die Wandlung der vom Pulsformspeicher ausgegebenen Daten im DAC in einen Ausgabepuls beeinflussen oder bestimmen. Insbesondere können die Daten aus dem Pulsformspeicher im Takt des vom Frequenzteiler ausgegebenen Signals ausgegeben werden und/oder die vom Pulsformspeicher ausgegebenen Daten können im Takt des Taktsignals im DAC in einen Ausgabepuls gewandelt werden. Mit anderen Worten generiert der rücksetzbare Frequenzteiler den Ausgabetakt bzw. das Taktsignal für die Pulsformausgabe und/oder die Ausgabepulserzeugung.

Durch das Startsignal oder ein damit in Beziehung stehendes Signal kann der Frequenzteiler für eine gewisse Zeit in einen Grundzustand gesetzt werden, d.h. einen Zustand, in dem kein Signal durch den Frequenzteiler ausgegeben wird. Während sich der Frequenzteiler im Grundzustand befindet, kann das Startsignal an den Pulsformspeicher gegeben werden, so dass die dort gespeicherten Daten freigegeben werden. Sobald der Frequenzteiler wieder frei gegeben wird, startet synchron die Ausgabe der Daten und somit der digital codierten Pulsformen aus dem Pulsformspeicher und/oder die Erzeugung des Ausgabepulses. Der Ausgabejitter ist somit um den Faktor des Frequenzteilers geringer als die des tatsächlichen Ausgabetaktes, d.h. der Frequenz des Ausgangssignals des rücksetzbaren Frequenzteilers. Beispielsweise kann die Taktquelle ein 600 MHz Signal erzeugen. Durch den Frequenzteiler kann dieses Signal durch vier geteilt werden, so dass der Ausgabetakt (Taktsignal) bei einer Frequenz von 150MHz liegt, was einer Periodendauer von 6,6 ns entspricht. Der Ausgabejitter beträgt in diesem Beispiel dann nur ca. 1,7 ns.

Im Startsignalpfad kann ein erster Impulsgeber angeordnet sein, dessen Ausgang mit dem Rücksetzanschluss der Takteinheit verbunden ist. Dem ersten Impulsgeber kann dabei ein Triggersignal zugeführt sein, aus dem im Startsignalpfad das Startsignal generiert wird. Durch den ersten Impulsgeber kann ein Signal erzeugt werden, dessen Pulsdauer lang genug ist, um die Takteinheit sicher zurückzusetzen bzw. zu starten. Somit kann sichergestellt werden, dass eine Synchronisation auf den / (einen) höheren Takt erfolgt und der Ausgabejitter möglichst gering gehalten wird.

Weiterhin kann im Startsignalpfad ein zweiter Impulsgeber vorgesehen sein, dessen Ausgang mit dem ersten Anschluss der Pulsformgenerierungseinrichtung verbunden ist. Als Eingangssignal erhält der zweite Impulsgeber vorzugsweise das Ausgangssignal des ersten Impulsgebers. Durch den zweiten Impulsgeber kann das eigentliche Startsignal generiert werden, welches dem Pulsformspeicher zugeführt wird.

Dabei ist es vorteilhaft, wenn der zweite Impulsgeber einen Puls mit größerer Pulsdauer erzeugt als der erste Impulsgeber. Die Pulsdauer des zweiten Impulsgebers sollte lang genug sein, dass die Wandlung der Daten des Pulsformspeichers durch den DAC in einen Ausgangspuls vollständig abgeschlossen werden kann.

Die Pulsformgenerierungseinrichtung kann monolithisch aufgebaut sein. Das bedeutet, dass der Pulsformspeicher zur Speicherung von Daten und der damit verbundene DAC in einem Baustein realisiert sein können.

Weiter kann die Takteinheit zumindest teilweise ebenfalls in diesem Baustein integriert sein. Insbesondere kann ein Quarzoszillator außerhalb des Bausteins realisiert sein und der Frequenzteiler im Baustein integriert sein.

Der Start-Stopp-Oszillator kann vollständig im Baustein integriert sein.

Der erste Impulsgeber kann ebenfalls im Baustein integriert sein.

Der zweite Impulsgeber kann ebenfalls im Baustein integriert sein.

Der Baustein kann ein programmierbarer Logikbaustein (PLD), insbesondere ein FPGA sein.

In den Rahmen der Erfindung fällt außerdem ein Verfahren zur Erzeugung eines Laserpulses mit den Schritten:
a. a. Ausgabe von Daten, insbesondere einer digital codierten Pulsform, von einem Pulsformspeicher an einen DAC in Reaktion auf ein Startsignal,
b. Erzeugen eines Ausgangspulses im DAC, insbesondere im Takt einer Takteinheit, und Ausgabe des Ausgangspulses, wobei
c. die Takteinheit auf das Startsignal oder ein mit dem Startsignal in Beziehung stehendes Signal synchronisiert wird.

Die Synchronisierung der Takteinheit auf das Startsignal oder ein mit dem Startsignal in Beziehung stehendes Signal kann dadurch erfolgen, dass die Takteinheit durch das Startsignal oder ein damit in Beziehung stehendes Signal zurückgesetzt oder vorübergehend in einen Grundzustand, in dem kein Taktsignal ausgegeben wird, versetzt werden kann. Insbesondere kann durch das Startsignal oder ein damit in Beziehung stehendes Signal festgelegt werden, wann die Takteinheit anfängt, ein Taktsignal auszugeben, das dem Pulsformspeicher und/oder dem DAC zugeführt wird.

Auf besonders einfache Art und Weise kann das Taktsignal der Takteinheit mittels eines Frequenzteilers erzeugt werden. Insbesondere kann dabei der Frequenzteiler durch das Startsignal oder ein mit dem Startsignal in Beziehung stehendes Signal zurückgesetzt bzw. angehalten und die Taktsignalausgabe wieder gestartet werden.

Gemäß einer alternativen Verfahrensvariante kann vorgesehen sein, dass das Taktsignal der Takteinheit durch einen Start-Stopp-Oszillator erzeugt wird. Dabei kann der Start-Stopp-Oszillator durch das Startsignal oder das mit dem Startsignal in Beziehung stehende Signal angehalten und wieder freigegeben/gestartet werden. Dadurch erfolgt die Synchronisierung mit dem Startsignal oder dem damit in Beziehung stehenden Signal.

Das Startsignal kann durch einen Impulsgeber erzeugt werden, wobei der Impulsgeber in einem Startsignalpfad angeordnet sein kann, auf dem ein Triggersignal in das Startsignal gewandelt wird. Ein Signal des Startsignalpfads kann verwendet werden, um die Takteinheit anzusteuern, insbesondere zurückzusetzen, und somit die Takteinheit mit dem Startsignal zu synchronisieren. Durch die Verwendung eines Impulsgebers kann ein Startsignal erzeugt werden, welches eine ausreichende Länge hat, um sicher zu stellen, dass die Wandlung der Daten durch den DAC in einen Ausgangspuls vollständig abgeschlossen werden kann. Das dem Impulsgeber zugeführte Signal kann als ein mit dem Startsignal in Beziehung stehendes Signal betrachtet werden und der Takteinheit zugeführt werden.

Das mit dem Startsignal in Beziehung stehende Signal kann durch einen Impulsgeber erzeugt werden. Dabei kann das Ausgangssignal des Impulsgebers dem weiteren Impulsgeber zugeführt werden, der daraus das Startsignal generiert. Durch den ersten Impulsgeber, der sich vorzugsweise im Startsignalpfad befindet, kann somit das mit dem Startsignal in Beziehung stehende Signal generiert werden.

Die Impulsgeber können dabei beispielsweise als monostabile Kippstufen ausgebildet sein. Dies bedeutet, dass sie für eine gewisse Zeit in einen "high"-Zustand versetzt werden und dann wieder einen "low"-Zustand einnehmen. Beispielsweise kann der erste Impulsgeber aus einem Triggersignal einen Puls mit einer Länge von 10ns generieren. Aus diesem Signal kann wiederum durch einen zweiten Impulsgeber ein Puls mit einer Länge von etwa 100ns erzeugt werden. Ein Signal bzw. ein Puls mit einer solchen Länge kann ausreichend sein, um sicher zu stellen, dass die von einem Pulsformspeicher ausgegebenen Daten vollständig durch den DAC in ein analoges Ausgangssignal bzw. einen Ausgangspuls gewandelt werden.

Weitere Merkmale und Vorteile der Erfindung ergeben sich aus der nachfolgenden Beschreibung von Ausführungsbeispielen der Erfindung, anhand der Figuren der Zeichnung, die erfindungswesentliche Einzelheiten zeigen, und aus den Ansprüchen. Die einzelnen Merkmale können je einzeln für sich oder zu mehreren in beliebiger Kombination bei einer Variante der Erfindung verwirklicht sein.

Bevorzuge Ausführungsbeispiele der Erfindung sind in der Zeichnung schematisch dargestellt und werden nachfolgend mit Bezug zu den Figuren der Zeichnung näher erläutert. Es zeigen:
- Fig. 1: einen Laserpulsgenerator;
- Fig. 2: eine erste Ausführungsform eines erfindungsgemäßen Laserpulsgenerators;
- Fig. 3: ein Diagramm zur Erläuterung der im Lasergenerator auftretenden Signale;
- Fig. 4: eine alternative Ausführungsform eines Laserpulsgenerators.

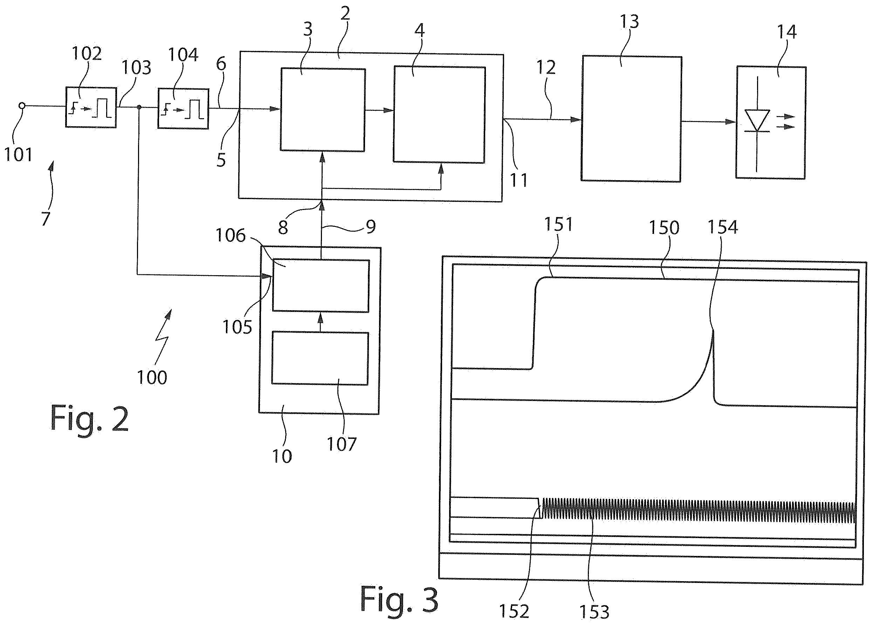

Bei der Ausführungsform eines erfindungsgemäßen Laserpulsgenerators 100 gemäß der Figur 2 wurden dieselben Bezugsziffern verwendet wie in der Figur 1 soweit entsprechende Elemente damit bezeichnet werden. Um einen Ausgangspuls des Digital-Analog-Wandlers 4 am Ausgangsanschluss 11 zu erzeugen, wird zunächst an der Stelle 101 dem Startsignalpfad 7 ein Triggersignal zugeführt. Aus diesem Triggersignal wird durch den Impulsgeber 102 ein Pulssignal generiert, welches am Ausgang 103 ausgegeben wird. Aus diesem Signal wird durch den Impulsgeber 104 ein Startsignal generiert, welches der Pulsformgenerierungseinrichtung 2 über die Startsignalleitung 6 des Startsignalpfads 7 und den ersten Anschluss 5 zugeführt wird. Das am Ausgang 103 ausgegebene Signal ist somit ein mit dem Startsignal in Beziehung stehendes Signal. Dieses Signal wird auch einem Rücksetzanschluss 105 der Takteinheit 10 zugeführt und dort insbesondere an einen Frequenzteiler 106 weitergeleitet. Das am Ausgang 103 ausgegebene Signal ist somit ein Rücksetzsignal. Es dient dazu, den Frequenzteiler 106 in einen Grundzustand zu versetzen. Dies bedeutet, dass für die Dauer des Pulses, der durch den Impulsgeber 102 generiert wird, der Frequenzteiler 106 in seinen Grundzustand versetzt wird. Sobald die fallende Flanke des vom Impulsgeber 102 erzeugten Pulses den Frequenzteiler 106 erreicht hat, darf der Frequenzteiler 106 ein Taktsignal ausgeben. Das Taktsignal weist dabei einen Bruchteil der Frequenz eines Taktsignals auf, welches durch die Taktquelle 107 generiert wird. Beispielsweise kann die Taktquelle 107 ein 600 MHz-Signal erzeugen, welches durch den Frequenzteiler 106 durch den Faktor 4 geteilt wird, so dass als Taktsignal ein Signal mit einer Frequenz von 150MHz der Pulsformgenerierungseinrichtung 2 am zweiten Anschluss 8 zugeführt wird.

Durch das am Anschluss 5 zugeführte Startsignal wird der Pulsformspeicher 3 freigegeben. Dies bedeutet, dass im Pulsformspeicher 3 gespeicherte Daten zur Ausgabe bereit sind. Diese Daten werden im Takt des durch die Takteinheit 10 ausgegebenen Taktes ausgegeben und an den Digital-Analog-Wandler 4 weitergegeben, wo aus den digitalen Daten des Pulsformspeichers 3 ein Ausgangspuls generiert wird, der am Anschluss 11 ausgegeben wird. Der Ausgangspuls wird einem Treiber 13 zugeführt, der eine Laserdiode 14 ansteuert. Im gezeigten Ausführungsbeispiel ist auch der Digital-Analog-Wandler 4 an die Takteinheit 10 angeschlossen, so dass der Digital-Analog-Wandler 4 mit demselben Taktsignal versorgt wird wie der Pulsformspeicher 3.

Der Impulsgeber 104 erzeugt einen Puls mit einer größeren Länge/Pulsbreite als der durch den Impulsgeber 102 erzeugte Puls. Die Länge des Pulses, der durch den Impulsgeber 104 erzeugt wird, ist vorzugsweise so gewählt, dass sichergestellt wird, dass die im Pulsformspeicher 3 gespeicherten Daten vollständig in den Ausgangspuls gewandelt werden. Beispielsweise kann der Impulsgeber 104 ein Ausgangssignal, insbesondere einen Puls, erzeugen, welcher eine Länge von ca. 100ns aufweist. Der Impulsgeber 102 kann ein Ausgangssignal am Ausgang 103 erzeugen, insbesondere einen Puls erzeugen, der eine Länge aufweist, die etwa ein Zehntel der Länge des Ausgangssignals, insbesondere Pulses, des Impulsgebers 104 beträgt. Im vorliegenden Ausführungsbeispiel kann die Dauer des ausgegebenen Pulses etwa 10ns betragen.

In der Figur 3 ist mit der Bezugsziffer 150 das Signal dargestellt, welches durch den Impulsgeber 102 erzeugt wird und am Ausgang 103 ausgegeben wird. Bei der steigenden Flanke 151 dieses Signals wird der Frequenzteiler 106 kurzzeitig ausgesetzt bzw. angehalten, was anhand der Lücke 152 zu erkennen ist. Anschließend wird ein synchrones Signal ausgegeben, welches ein Viertel der Frequenz des Signals der Taktquelle 107 aufweist. Dies ist durch die Bezugsziffer 153 dargestellt. Mit der Bezugsziffer 154 ist der Ausgangspuls bezeichnet, der am Ausgang 11 ausgegeben wird, aufgrund der Umwandlung der im Pulsformspeicher 3 abgelegten Daten in ein Analogsignal durch den Digital-Analog-Wandler 4. Es ist zu erkennen, dass dieses Signal einen verringerten Jitter aufweist.

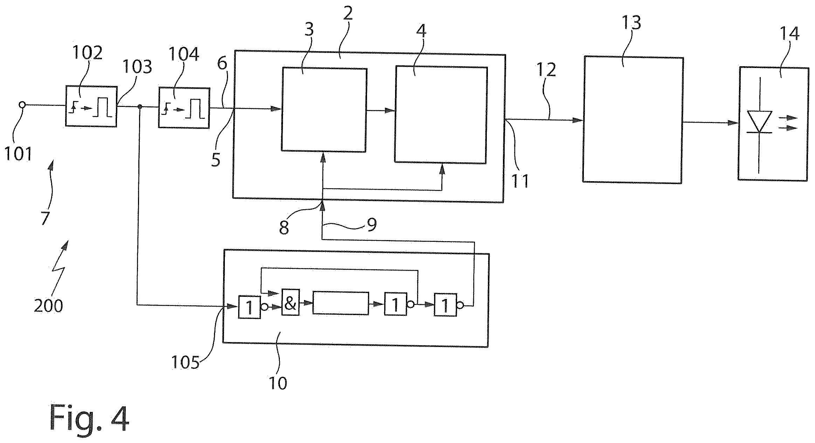

Die Figur 4 entspricht im Wesentlichen der Figur 2. Soweit dieselben Elemente vorhanden sind, werden dieselben Bezugsziffern verwendet. Der grundlegende Unterschied der Figur 4 zur Figur 2 ist, dass die Takteinheit 10 als Start-Stopp-Oszillator ausgebildet ist. Durch das über den Anschluss 105 zugeführte Signal kann der Start-Stopp-Oszillator gestartet und gestoppt werden. Insbesondere kann der Start-Stopp-Oszillator mit einem Signal, welches mit dem Startsignal in Beziehung steht, nämlich dem Signal, welches am Ausgang 103 des Impulsgebers 102 ausgegeben wird, synchronisiert werden. Durch das mit dem Startsignal in Beziehung stehende Signal kann der Start-Stopp-Oszillator kurz angehalten werden. Solange der Start-Stopp-Oszillator angehalten ist, kann die Pulsformfreigabe durch das Startsignal erteilt werden. Anschließend kann der Start-Stopp-Oszillator freigegeben werden und im Takt des Taktsignals, das vom Start-Stopp-Oszillator erzeugt wird, die digitalisierte Pulsform aus dem Pulsformspeicher 3 ausgegeben und durch den Digital-Analog-Wandler 4 das Ausgangssignal erzeugt werden. Der analoge Start-Stopp-Oszillator, welcher die Takteinheit 10 bildet, ist nur sehr schematisch angegeben. Es sind viele unterschiedliche Lösungen zur Realisierung eines Start-Stopp-Oszillators, insbesondere eines analogen Start-Stopp-Oszillators, denkbar. Wenn die Takteinheit 10 als Start-Stopp-Oszillator ausgebildet ist, lässt sich der Jitter noch weiter reduzieren.

In allen Ausführungsbeispielen kann die Pulsformgenerierungseinrichtung 2 monolithisch aufgebaut sein. Das bedeutet, dass der Pulsformspeicher 3 zur Speicherung von Daten und der damit verbundenen Digital-Analog-Wandler (DAC) 4 in einem Baustein realisiert sein können.

Weiter kann die die Takteinheit 10 zumindest teilweise ebenfalls in diesem Baustein integriert sein. So kann ein Quarzoszillator außerhalb des Bausteins realisiert sein, der Frequenzteiler 106 aber im Baustein integriert sein.

Der Start-Stopp-Oszillator kann vollständig im Baustein integriert sein. Der erste Impulsgeber 102 kann ebenfalls im Baustein integriert sein.

Der zweite Impulsgeber 104 kann ebenfalls im Baustein integriert sein. Der Baustein kann ein programmierbarer Logikbaustein (PLD), insbesondere ein FPGA, sein.

## Patentansprüche

1. Laserpulsgenerator (100, 200) mit
a. einer Pulsformgenerierungseinrichtung (2), aufweisend
i. einen Pulsformspeicher (3) zur Speicherung von Daten und einen damit verbundenen Digital-Analog-Wandler (DAC)(4),
ii. einen ersten Anschluss (5) zum Anschluss einer Startsignalleitung (6) eines Startsignalpfads (7),
iii. einen zweiten Anschluss (8) zum Anschluss einer Taktsignalleitung (9),
iv. einen dritten Anschluss (11) zum Anschluss einer Pulsleitung (12), wobei der erste und zweite Anschluss (5, 8) so mit dem Pulsformspeicher (3) und dem DAC (4) verbunden sind, dass bei einem vorgegebenen Startsignal Daten vom Pulsformspeicher (3) zum DAC (4) geleitet und vom DAC (4), insbesondere im Takt eines Taktsignals, in einen Ausgangspuls gewandelt wird, der am dritten Anschluss (11) zur Ansteuerung eines Treibers (13) für eine Laserdiode (14) bereitgestellt wird,
b. eine Takteinheit (10), die mit dem zweiten Anschluss (8) über die Taktsignalleitung (9) verbunden ist, **dadurch gekennzeichnet, dass**
c. die Takteinheit (10) einen Rücksetzanschluss (105) aufweist, der mit dem Startsignalpfad (7) verbunden ist.

2. Laserpulsgenerator nach Anspruch 1, **dadurch gekennzeichnet, dass** die Takteinheit (10) als Start-Stopp-Oszillator ausgebildet ist.

3. Laserpulsgenerator nach Anspruch 1, **dadurch gekennzeichnet, dass** die Takteinheit (10) einen rücksetzbaren Frequenzteiler (106) und eine Taktquelle (107) aufweist.

4. Laserpulsgenerator nach einem der vorhergehenden Ansprüche,
**dadurch gekennzeichnet, dass** im Startsignalpfad (7) ein erster Impulsgeber (102) angeordnet ist, dessen Ausgang (103) mit dem Rücksetzanschluss (105) der Takteinheit (10) verbunden ist.

5. Laserpulsgenerator nach einem der vorhergehenden Ansprüche,
**dadurch gekennzeichnet, dass** ein zweiter Impulsgeber (104) vorgesehen ist, dessen Ausgang mit dem ersten Anschluss (5) der Pulsformgenerierungseinrichtung (2) verbunden ist.

6. Verfahren zur Erzeugung eines Laserpulses mit den Schritten:
a. Ausgabe von Daten, insbesondere einer digital codierten Pulsform, von einem Pulsformspeicher (3) an einen DAC (4) in Reaktion auf ein Startsignal,
b. Erzeugen eines Ausgangspulses im DAC (4), im Takt eines Taktsignals einer Takteinheit (10), und Ausgabe des Ausgangspulses,
**dadurch gekennzeichnet, dass**
c. die Takteinheit (10) auf das Startsignal oder ein mit dem Startsignal in Beziehung stehendes Signal synchronisiert wird.

7. Verfahren nach Anspruch 6, **dadurch gekennzeichnet, dass** das Taktsignal in der Takteinheit (10) mittels eines Frequenzteilers (106) erzeugt wird.

8. Verfahren nach Anspruch 6, **dadurch gekennzeichnet, dass** das Taktsignal der Takteinheit (10) durch einen Start-Stopp-Oszillator erzeugt wird.

9. Verfahren nach einem der vorhergehenden Ansprüche 6 bis 8, **dadurch gekennzeichnet, dass** das Startsignal durch einen Impulsgeber (104) erzeugt wird.

10. Verfahren nach einem der vorhergehenden Ansprüche 6 bis 9, **dadurch gekennzeichnet, dass** ein mit dem Startsignal in Beziehung stehendes Signal durch einen Impulsgeber (102) erzeugt wird.

11. Laserpulsgenerator nach einem der vorhergehenden Ansprüche 1 bis 5, **dadurch gekennzeichnet, dass** der Rücksetzanschluss (105) an der Takteinheit (10) derart ausgebildet ist, dass eine Synchronisierung der Takteinheit (10) mit dem Startsignal oder einem damit in Beziehung stehenden Signal erfolgt.

12. Verwendung eines Laserpulsgenerators (100, 200) nach einem der Ansprüche 1 bis 5 oder 11 oder des Verfahrens nach einem der Ansprüche 6 bis 10
- zur Ansteuerung eines Treibers (13) für eine Laserdiode (14).

13. Verwendung eines Laserpulsgenerators (100, 200) nach einem der Ansprüche 1 bis 5 oder 11 oder des Verfahrens nach einem der Ansprüche 6 bis 10 oder einer Verwendung nach Anspruch 12
- zur Reduzierung des Ausgabejitters des Ausgangspulses.

## Claims

1. Laser pulse generator (100, 200) having
a. a pulse shape generation device (2), having
i. a pulse shape store (3) for storing data and a digital/analogue converter (DAC) (4) which is connected thereto,
ii. a first connection (5) for connecting a start signal line (6) of a start signal path (7),
iii. a second connection (8) for connecting a clock signal line (9),
iv. a third connection (11) for connecting a pulse line (12), wherein the first and second connections (5, 8) are connected to the pulse shape store (3) and the DAC (4) in such a manner that, with a predetermined start signal, data are directed from the pulse shape store (3) to the DAC (4) and are converted by the DAC (4), in particular at the rate of a clock signal, into an output pulse which is provided at the third connection (11) for controlling a driver (13) for a laser diode (14),
b. a clock unit (10) which is connected to the second connection (8) via the clock signal line (9),
**characterised in that**
c. the clock unit (10) has a reset connection (105) which is connected to the start signal path (7).

2. Laser pulse generator according to claim 1, **characterised in that** the clock unit (10) is constructed as a start/stop oscillator.

3. Laser pulse generator according to claim 1, **characterised in that** the clock unit (10) has a resettable frequency divider (106) and a clock source (107).

4. Laser pulse generator according to any one of the preceding claims, **characterised in that** there is arranged in the start signal path (7) a first pulse generator (102) whose output (103) is connected to the reset connection (105) of the clock unit (10).

5. Laser pulse generator according to any one of the preceding claims, **characterised in that** there is provided a second pulse generator (104) whose output is connected to the first connection (5) of the pulse shape generation device (2) .

6. Method for producing a laser pulse having the steps of:
a. outputting data, in particular a digitally encoded pulse shape, from a pulse shape store (3) to a DAC (4) in response to a start signal,
b. producing an output pulse in the DAC (4) at the rate of a clock signal of a clock unit (10), and outputting the output pulse,
**characterised in that**
c. the clock unit (10) is synchronised to the start signal or a signal which is related to the start signal.

7. Method according to claim 6, **characterised in that** the clock signal in the clock unit (10) is produced by means of a frequency divider (106).

8. Method according to claim 6, **characterised in that** the clock signal of the clock unit (10) is produced by means of a start/stop oscillator.

9. Method according to any one of the preceding claims 6 to 8, **characterised in that** the start signal is produced by a pulse generator (104).

10. Method according to any one of the preceding claims 6 to 9, **characterised in that** a signal related to the start signal is produced by a pulse generator (102).

11. Laser pulse generator according to any one of the preceding claims 1 to 5, **characterised in that** the reset connection (105) is constructed in the clock unit (10) in such a manner that a synchronisation of the clock unit (10) with the start signal or a signal related thereto is carried out.

12. Use of a laser pulse generator (100, 200) according to any one of claims 1 to 5 or 11 or the method according to any one of claims 6 to 10,
- for controlling a driver (13) for a laser diode (14).

13. Use of a laser pulse generator (100, 200) according to any one of claims 1 to 5 or 11 or the method according to any one of claims 6 to 10 or a use according to claim 12
- for reducing the output jitter of the output pulse.

## Revendications

1. Générateur d'impulsions laser (100, 200) comprenant
a. un dispositif de génération de forme d'impulsion (2) comportant
i. une mémoire de formes d'impulsion (3) destinée à mémoriser des données et un convertisseur numérique-analogique (DAC) (4) associé,
ii. une première borne (5) destinée à raccorder une ligne de signal de démarrage (6) d'un chemin de signal de démarrage (7),
iii. une deuxième borne (8) destinée à raccorder une ligne de signal d'horloge (9),
iv. une troisième borne (11) destinée à raccorder une ligne d'impulsions (12), la première et la deuxième bornes (5, 8) étant reliées à la mémoire de formes d'impulsion (3) et au DAC (4) de telle sorte que, lors d'un signal de démarrage spécifié, les données soient acheminées de la mémoire de formes d'impulsion (3) au DAC (4) et converties par le DAC (4), en particulier au rythme d'un signal d'horloge, en une impulsion de sortie qui est délivrée à la troisième borne (11) pour commander un pilote (13) destiné à une diode laser (14),
b. une unité d'horloge (10) qui est reliée à la deuxième borne (8) par le biais de la ligne de signal d'horloge (9),
**caractérisé en ce que**
c. l'unité d'horloge (10) comporte une borne de réinitialisation (105) qui est reliée au chemin de signal de démarrage (7).

2. Générateur d'impulsions laser selon la revendication 1, **caractérisé en ce que** l'unité d'horloge (10) est conçue comme un oscillateur marche-arrêt.

3. Générateur d'impulsions laser selon la revendication 1, **caractérisé en ce que** l'unité d'horloge (10) comporte un diviseur de fréquence réinitialisable (106) et une source d'horloge (107).

4. Générateur d'impulsions laser selon l'une des revendications précédentes, **caractérisé en ce qu'**un premier générateur d'impulsions (102), dont la sortie (103) est reliée à la borne de réinitialisation (105) de l'unité d'horloge (10), est disposé dans le chemin de signal de démarrage (7).

5. Générateur d'impulsions laser selon l'une des revendications précédentes, **caractérisé en ce qu'**un deuxième générateur d'impulsions (104) est prévu dont la sortie est reliée à la première borne (5) du dispositif de génération de formes d'impulsion (2).

6. Procédé de génération d'une impulsion laser comprenant les étapes suivantes :
a. délivrer des données, en particulier d'une forme d'impulsion codée numériquement, d'une mémoire de forme d'impulsion (3) à un DAC (4) en réponse à un signal de démarrage,
b. générer une impulsion de sortie dans le DAC (4) au rythme d'un signal d'horloge d'une unité d'horloge (10) et délivrer l'impulsion de sortie,
**caractérisé en ce que**
c. l'unité d'horloge (10) est synchronisée avec le signal de démarrage ou un signal lié au signal de démarrage.

7. Procédé selon la revendication 6, **caractérisé en ce que** le signal d'horloge de l'unité d'horloge (10) est généré au moyen d'un diviseur de fréquence (106).

8. Procédé selon la revendication 6, **caractérisé en ce que** le signal d'horloge de l'unité d'horloge (10) est généré par un oscillateur marche-arrêt.

9. Procédé selon l'une des revendications 6 à 8 précédentes, **caractérisé en ce que** le signal de démarrage est généré par un générateur d'impulsions (104).

10. Procédé selon l'une des revendications 6 à 9 précédentes, **caractérisé en ce qu'**un signal lié au signal de démarrage est généré par un générateur d'impulsions (102) .

11. Générateur d'impulsions laser selon l'une des revendications précédentes 1 à 5, **caractérisé en ce que** la borne de réinitialisation (105) de l'unité d'horloge (10) est conçue de façon à effectuer une synchronisation de l'unité d'horloge (10) avec le signal de démarrage ou un signal lié à celui-ci.

12. Utilisation d'un générateur d'impulsions laser (100, 200) selon l'une des revendications 1 à 5 ou 11 ou du procédé selon l'une des revendications 6 à 10
- pour commander un pilote (13) destiné à une diode laser (14).

13. Utilisation d'un générateur d'impulsions laser (100, 200) selon l'une des revendications 1 à 5 ou 11 ou du procédé selon l'une des revendications 6 à 10 ou d'une utilisation selon la revendication 12
- pour réduire la gigue de sortie de l'impulsion de sortie.
